# EUROPÄISCHE PATENTSCHRIFT

(11) **EP 2 408 945 B1**
(45) Veröffentlichungstag und Bekanntmachung des Hinweises auf die Patenterteilung: **27.06.2018**
(21) Anmeldenummer: 10709834.5
(22) Anmeldetag: 18.03.2010
(51) Int. Cl.: C23C 14/08, C23C 30/00

(54) **SCHNEIDWERKZEUG**
CUTTING TOOL
OUTIL DE COUPE

(30) Priorität: 19.03.2009 DE 102009001675
(43) Veröffentlichungstag der Anmeldung: 25.01.2012
(73) Patentinhaber: Walter AG, 72072 Tübingen (DE)
(72) Erfinder: EIBL, Oliver, 72138 Kirchentellinsfurt (DE); SCHIER, Veit, 70771 Leinfelden-Echterdingen (DE); ENGELHART, Wolfgang, 72555 Metzingen (DE)
(74) Vertreter: WSL Patentanwälte Partnerschaft mbB
(86) Internationale Anmeldenummer: PCT/EP2010/053551
(87) Internationale Veröffentlichungsnummer: WO 2010/106142

(56) Entgegenhaltungen:
- WO-A1-92/17623
- WO-A2-2009/003755
- JP-A- 59 028 565
- JP-A- 2005 262 355
- YAMAGUCHI S: "Electron Diffraction Analysis of Al2O3 of Gamma-Type", FRESENIUS' ZEITSCHRIFT FUER ANALYTISCHE CHEMIE, vol. 269, no. 3, 18 June 1974 (1974-06-18) , pages 191-193, XP055297675, Springer-Verlag [DE] ISSN: 0016-1152, DOI: 10.1007/BF00445954

## Beschreibung

### Gegenstand der Erfindung

Die Erfindung betrifft ein Schneidwerkzeug mit einem Substratgrundkörper und einer darauf aufgebrachten ein- oder mehrlagigen Beschichtung, wobei wenigstens eine Lage der Beschichtung eine im PVD-Verfahren oder im CVD-Verfahren hergestellte Metalloxidlage ist.

### Hintergrund der Erfindung

Schneidwerkzeuge bestehen aus einem Grundkörper, der beispielsweise aus Hartmetall, Cermet, Stahl oder Schnellarbeitsstahl hergestellt ist. Zur Erhöhung der Standzeiten oder auch zur Verbesserung der Schneideigenschaften wird auf den Grundkörper häufig eine ein- oder mehrlagige Beschichtung aufgebracht. Diese Beschichtung umfasst beispielweise metallische Hartstoffschichten, Oxidschichten und dergleichen. Zum Aufbringen der Beschichtung werden CVD-Verfahren (chemische Gasphasenabscheidung; chemical vapour deposition) und/oder PVD-Verfahren (physikalische Gasphasenabscheidung; physical vapour deposition) angewendet. Mehre Lagen innerhalb einer Beschichtung können ausschließlich mittels CVD-Verfahren, ausschließlich mittels PVD-Verfahren oder durch eine Kombination dieser Verfahren aufgebracht werden.

Bei den PVD-Verfahren unterscheidet man zwischen verschiedenen Verfahrensvarianten, wie Magnetronsputtern, Lichtbogenverdampfen (Arc-PVD), Ionenplattierung, Elektronenstrahlverdampfung und Laserablation. Magnetronsputtern und Lichtbogenverdampfen zählen zu den am häufigsten für die Beschichtung von Werkzeugen angewendeten PVD-Verfahren. Innerhalb einzelner PVD-Verfahrensvarianten gibt es wiederum unterschiedliche Modifikationen, wie beispielweise ungepulstes oder gepulstes Magnetronsputtern oder ungepulstes oder gepulstes Lichtbogenverdampfen usw.

Das Target im PVD-Verfahren kann aus einem reinen Metall oder einer Kombination von zwei oder mehr Metallen bestehen. Umfaßt das Target mehrere Metalle, so werden alle diese Metalle gleichzeitig in die bei dem PVD-Verfahren aufgebaute Lage einer Beschichtung eingebaut.

Das Mengenverhältnis der Metalle zueinander in der aufgebauten Lage wird von dem Mengenverhältnis der Metalle in dem Target abhängen, aber auch von den Bedingungen in dem PVD-Verfahren, da einzelne Metalle unter bestimmten Bedingungen in höheren Mengen aus dem Target herausgelöst werden und/oder sich in höheren Mengen auf dem Substrat abscheiden als andere Metalle. Neben den reinen Metallen kommen in Targets auch oxidische, nitridische, carbidische Formen der Metalle oder Mischungen davon zum Einsatz.

Zur Erzeugung bestimmter Metallverbindungen werden dem Reaktionsraum des PVD-Verfahrens reaktive Gase zugeführt, wie z.B. Stickstoff zur Erzeugung von Nitriden, Sauerstoff zur Erzeugung von Oxiden, kohlenstoffhaltige Verbindungen zur Erzeugung von Carbiden, Carbonitriden, Oxicarbiden etc. oder Gemische dieser Gase zur Erzeugung von entsprechenden Mischverbindungen.

Beim PVD-Verfahren wird an die zu beschichtenden Substrate in der Regel ein sogenanntes Bias-Potential angelegt, um die für den Aufwachsprozess notwendige Oberflächenenergie und damit Atombeweglichkeit zu erreichen. Die Energie ist notwendig, um bei einer aufwachsenden Schicht kristalline Strukturen zu erzielen. Beim Aufbringen von isolierenden Schichten im PVD-Verfahren, was beispielsweise auf eine Vielzahl von Metalloxidverbindungen zutrifft, verringert sich aufgrund der isolierenden Eigenschaften des Schichtmaterials das effektiv angelegte Bias-Potential während des Aufwachsprozesses mit zunehmender Schichtdicke, was die Aufwachsbedingungen an der Schichtoberfläche verschlechtert und im weiteren schließlich zum Aufwachsen von ausschließlich oder hauptsächlich amorphen Strukturen führen kann.

Ramm, J. et al., Pulse enhanced electron emission (P3e™) arc evaporation and the synthesis of wear resistant Al-Cr-O coatings in corundum structure, Surface & Coatings Technology 202 (2007), S. 876-883, beschreiben die Abscheidung von Aluminiumoxid-Chromoxid-Schichten durch gepulstes Lichtbogenverdampfen (Arc-PVD). Die abgeschiedenen Schichten zeigen zunächst eine Mischkristallstruktur.

Teixeira, V. et al., Deposition of composite and nanolaminate ceramic coatings by sputtering, Vacuum 67 (2002), S. 477-483, beschreiben das Abscheiden von dünnen Zirconiumoxid/Aluminiumoxid-Schichten im Nanometerbereich durch Magnetronsputtern. Die Schichten zeigen kristalline Anteile von Zirconiumoxid, aber lediglich amorphe Anteile an Aluminiumoxid.

Trinh, D. H. et al., Radio frequency dual magnetron sputtering deposition and characterization of nanocomposite AI203 - ZrO2 thin films, J. Vac. Sc. Techn. A 24(2), März/April 2006, S. 309-316 beschreiben das Abscheiden sehr dünner Zirconiumoxid/Aluminiumoxid-Schichten im Nanometerbereich durch Magnetronsputtern, welche kristalline Anteile an tetragonalem Zirconiumoxid zeigen, jedoch nur amorphe Anteile an Aluminiumoxid.

Die WO-A-2007/121954 beschreibt die Herstellung einer Hartstoffschicht auf einem Substrat mittels Magnetronzerstäuben, wobei die Hartstoffschicht die metallischen Elemente Al, Cr und Si sowie nicht-metallische Elemente aus der Gruppe B, C, N, O enthält. Der atomare Anteil von Sauerstoff an den nicht-metallischen Elementen ist grösser als 30%. Die Hartstoffschicht enthält bevorzugt kristalline Phasen und/oder Mischphasen im System Al-Cr-Si-O. Es können sich sowohl kubische Phasen der Raumgruppe Fd3m als auch hexagonale Phasen der Raumgruppe R-3C ausbilden.

Die EP-A-1 029 105 und die EP-A-1 253 215 beschreiben beschichtete Schneidwerkzeuge für die Metallbearbeitung mit einem Hartmetall-, Cermet- oder Keramikkörper und einer harten und verschleiß- und hitzebeständigen Beschichtung, die nach der DMS- (Duales Magnetron Sputtern) PVD-Methode abgeschieden ist, wobei wenigstens eine Schicht, vorzugsweise die äußerste, aus Al₂O₃ besteht und weitere Schichten, wenn überhaupt vorhanden, zwischen dem Werkzeugkörper und der Al₂O₃-Schicht aus Metallnitriden und/oder -carbiden der Metallelemente Ti, Nb, Hf, V, Ta, Mo, Zr, Cr, W und/oder Al hergestellt sind. Die Al₂O₃-Schichten bestehen aus dichtem, feinkörnigem, kristallinem γ-Al₂O₃ und können auch andere Phasen aus der γ-Reihe enthalten. WO 92/17623 A offenbart ein mit Al₂O₃ beschichtetes Schneidwerkzeug aus einem Hartmetall-, Stahl oder Cermet-Substratkörper, wobei die Schicht ein Gefüge von feinkristallinem α- und amorphen Aluminiumoxid aufweist. Der Nachweis des Gefüges erfolgt elektronenmikroskopisch über eine Debye-Scherrer-Aufnahme.

JP 2005 262355 A offenbart, Hartmetall-Schneidwerkzeuge mit Oxidschichten, unter anderem Al₂O₃ und Al₂O₃ + Cr₂O₃, durch ein Verfahren unter bevorzugter Verwendung eines dualen Magnetrons zu beschichten. Diese Schichten sind entweder α- oder γ-kristallin oder amorph. Die Schichtdicke der Oxidschicht kann 0.01 - 5 µm betragen Zusätzlich kann eine Deckschicht eines Carbids, Borids und/oder Carbonitrids von Elemente der Gruppen IVa bis Via des Periodensystems, Si und/oder Al vorhanden sein. Es sind somit rein kristalline und rein amorphe Systeme sowie Systeme mit kristallinen Körnern in amorpher Matrix aus dem Stand der Technik bekannt. Die kristallinen Phasen umfassen binäre Systeme oder Mischkristalle bekannter Kristallsysteme.

Als Verfahren zur Untersuchung von Metalloxidschichten werden Röntgen- und Elektronenbeugung verwendet, um die in der Kristallstruktur auftretenden Netzebenenabstände (d-Werte) zu bestimmen und/oder um amorphe Strukturen nachzuweisen. Hierbei ist die Elektronenbeugung gegenüber der Röntgenbeugung wegen der geringeren Wellenlänge zur Untersuchung fehlgeordneter Körner mit Korngrößen von 10-50 nm vorteilhafter.

### Aufgabe

Die Aufgabe der vorliegenden Erfindung bestand darin, gegenüber dem Stand der Technik verbesserte beschichtete Schneidwerkzeuge bereitzustellen, insbesondere solche, die gegenüber Schneidwerkzeugen mit ähnlichem Beschichtungsaufbau eine höhere Härte, verbesserte Verschleißeigenschaften und/oder verbesserte (verminderte) Wärmeleitfähigkeit besitzen.

### Beschreibung der Erfindung

Gelöst wird die erfindungsgemäße Aufgabe durch ein Schneidwerkzeug gemäß Anspruch 1. Bevorzugte Ausführungsformen sind in den Ansprüchen 2 bis 8 definiert. Das bevorzugte Verfahren der Elektronenbeugung ist Transmissionselektronenmikroskopie (TEM), jedochsind auch andere Verfahren zur Erzeugung von Elektronenbeugungsbildern bekannt und geeignet.

Die für amorphe Strukturen typische Intensitätsverteilung ist auch als diffus zu bezeichnen. Wenn hierin von einer Mehrzahl der vorhandenen Körner die Rede ist, die die erfindungsgemäße Struktur aufweisen, dann ist damit gegenüber weiteren Körnern in der gleichen Lage eine überwiegende Anzahl gemeint, vorzugsweise über 50%, besonders bevorzugt über 70%, ganz besonders bevorzugt über 90%.

Elektronenbeugungsbilder der erfindungsgemäßen Kornstruktur in der Metalloxidlage wurden bezüglich der d-Werte (Netzebenenabstände) ausgewertet und es ergab sich für die erfindungsgemäße mit Unordnung behaftete Kristallstruktur der Körner der Metalloxidlage, dass punktförmige Reflexe nur bis zu einem gewissen d-Wert auftraten (d_{GRENZ}) und für größer Netzebenenabstände d (kleinere Streuwinkel) oberhalb d_{GRENZ} keine punktförmigen Reflexe, die auf Ringen angeordnet waren, mehr beobachtet wurden, sondern eine Intensitätsverteilung der gestreuten Elektronen, wie sie amporphe Strukturen zeigen. Bei einem Vergleich der experimentell erhaltenen d-Werte mit den zu erwartenden d-Werten (die für die jeweilige Verbindung tabelliert zur Verfügung stehen (z.B. ICSD Datenbank)) stellte man fest, dass Reflexe fehlten, die einen d-Wert größer d_{GRENZ} aufweisen sollten. Im Beugungsbild der erfindungsgemäßen Struktur fehlt bei Netzebenenabständen größer als d_{GRENZ} also mindestens ein Reflex, den man bei der geordneten Struktur der gleichen Verbindung finden bzw. erwarten würde.

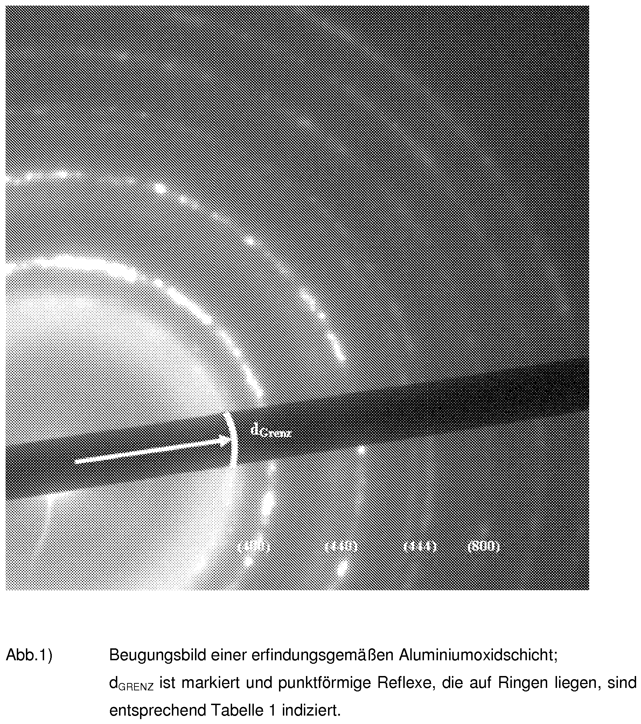

Ein Beugungsbild wie es typisch für eine solche erfindungsgemäße Kristallstruktur einer Metalloxidlage ist, ist in Abb. 1 für eine Aluminiumoxidschicht gezeigt. Der d-Wert d_{GRENZ} ist eingetragen und zeigt, dass punktförmige Reflexe auf Ringen angeordnet nur für d-Werte d < c beobachtet werden. Im Beugungsbild steigt der d-Wert zum Mittelpunkt der Ringe bzw. der scheibenförmigen Reflexe hin an.

Die nachfolgende Tabelle 1 zeigt die experimentell bestimmten d-Werte im Vergleich zu den für Gamma Aluminiumoxid erwarteten d-Werten. In diesem Fall betrug d_{GRENZ} 0,2 nm und alle Reflexe mit Netzebenenabstand > 0, 2nm, die für die Kristallstruktur von Gamma Aluminiumoxid auftreten sollten, wurden nicht beobachtet. Der Grenzwert d_{GRENZ} kann aus elektronenmikroskopischen Beugungsbildern genau bestimmt werden und ermöglicht so, die Unordnung der Kristallstruktur in der Metalloxidlage zu quantifizieren. Der Nachweis, dass es sich tatsächlich bei den Körnern in der Metalloxidlage um eine Struktur mit fehlender Fernordnung handelt, ist dadurch erbracht, dass in einem Bereich des Beugungsbilds (d < d_{GRENZ}) punktförmige Reflexe auftreten, die auf Ringen angeordnet sind, und im komplementären Bildbereich (d > d_{GRENZ}) ein Intensitätsprofil auftritt, wie es für amorphe Strukturen typisch ist, und dass ein Korn anteilig seinem Kornvolumen in beide Bildbereiche des Beugungsbildes Intensitätsbeiträge liefert. Letzteres wurde über Dunkelfeldbilder im TEM nachgewiesen.

**Tabelle 1**

| **tabellierte Daten** | | **experimentell bestimmte d-Werte** |
|---|---|---|
| **hkl** | d- Werte **[Å]** | |
| 111 | 4,58 | --- |
| 220 | 2,81 | --- |
| 311 | 2,39 | --- |
| 222 | 2,29 | --- |
| 400 | 1,98 | 1,96 |
| 422 | 1,62 | 1,51 |
| 511 | 1,52 | 1,38 |
| 440 | 1,40 | 1,18 |
| 444 | 1,14 | 1,13 |
| | | 0,99 |
| | | 0,87 |
| | | 0,80 |

Die in der Beschichtung des erfindungsgemäßen Werkzeugs vorhandene Metalloxidlage besitzt eine neuartige Struktur, die sich am besten durch Elektronenbeugung, vorzugsweise Transmissionselektronenmikroskopie (TEM), aber auch in Kombination mit Röntgenbeugung (XRD), nachweisen lässt. Im Elektronenbeugungsbild ist erkennbar, dass innerhalb der für die neue Struktur charakteristischen Körner eine strukturelle Unordnung vorhanden ist, aber dennoch eine Art der Fernordnung bzw. Kristallinität vorliegen muss. Alternativ lässt sich die neuartige Struktur auch durch eine Kombination aus Röntgenbeugung (XRD) und Härtemessung nachweisen. Die neuartige Struktur zeigt im XRD wenige aber breite Reflexe und eine sehr hohe Intensität des Untergrunds. Sie besitzt gegenüber einer rein amorphen Struktur gleicher Zusammensetzung eine deutlich höhere Härte. Anspruchsgemäß wird die neuartige Struktur hierin jedoch über die Elektronenbeugungsdaten definiert.

Die hierin angegebene Definition der erfindungsgemäßen Metalloxidlage unter Bezugnahme auf die Ergebnisse der Elektronenbeugung unterscheidet Körner der erfindungsgemäßen Metalloxidlage von rein kristallinen oder polykristallinen Strukturen, von amorphen Strukturen oder von Strukturen mit polykristallinen Anteilen in amorpher Matrix. Die Elektronenbeugungsbilder der erfindungsgemäßen Metalloxidlage bzw. der Kornstrukturen in dieser Metalloxidlage entsprechen keiner der vorgenannten Strukturen, ähneln aber am ehesten Strukturen mit polykristallinen Anteilen in einer amorphen Matrix. Allerdings liegen bei solchen Strukturen kristalline Anteile eingebettet in amorphe Bereiche oder neben amorphen Bereichen vor. Die Elektronenbeugungsbilder solcher Strukturen unterscheiden sich von den Elektronenbeugungsbildern der erfindungsgemäßen Strukturen in den hierin beschriebenen charakteristischen Merkmalen, so dass für den Fachmann eine eindeutige Unterscheidung einfach möglich ist.

Ohne dass die Erfinder sich hiermit an eine Theorie binden wollen, ist die Besonderheit der erfindungsgemäßen Struktur nach den Ergebnissen der Elektronenbeugungsbilder darin zu sehen, dass einzelne Körner sowohl Elektronenbeugungsreflexe zeigen, die typisch für kristalline Strukturen sind, als auch solche, die typisch für nicht-kristalline Strukturen sind. Interpretiert und bezeichnet wird dies hierin als "strukturelle Unordnung" in einem ansonsten kristallin erscheinenden Korn.

Mit den erfindungsgemäßen Strukturen gehen überraschenderweise wenigstens zwei vorteilhafte Eigenschaften der Beschichtung des Substratgrundkörpers und damit des gesamten Schneidwerkzeugs einher. Es wurde festgestellt, dass Beschichtungen mit einer Metalloxidlage der erfindungsgemäßen Art eine erheblich höhere Härte (Vickers-Härte) aufweisen können als kristalline Metalloxidlagen, welche die gleiche oder ähnliche Zusammensetzung und Dicke aufweisen, die jedoch nicht die charakteristische strukturelle Unordnung besitzen bzw. die charakteristischen Elektronenbeugungsergebnisse liefern. In einer bevorzugten Ausführungsform der Erfindung weist die wenigstens eine Metalloxidlage gegenüber einer rein kristallinen Metalloxidlage gleicher Zusammensetzung und Dicke eine um 10 %, vorzugsweise um 20 %, weiter bevorzugt um 40 %, besonders bevorzugt um 70 % höhere Vickers-Härte auf.

Beispielsweise wurde für eine mittels CVD abgeschiedene grobkristalline Aluminiumoxid-Lage (3 µm Dicke; nicht erfindungsgemäß) eine Vickers-Härte von 1700 HV gemessen. Zum Vergleich wurde mittels dualem Magnetron-PVD-Verfahren eine Aluminiumoxid-Lage gleicher Dicke (3 µm) der erfindungsgemäßen Art abgeschieden und eine Vickers-Härte von 2300 HV bestimmt. Bei einer mittels dualem Magnetron-PVD-Verfahren mit einem gemischten Target (70 At.-% Al und 30 At.-% Cr) abgeschiedenen Aluminium-Chromoxid-Lage der erfindungsgemäßen Art wurde eine Vickers-Härte von 3800 HV gemessen.

Die erfindungsgemäßen Strukturen, die sich im Elektronenbeugungsbild eindeutig von nichterfindungsgemäßen Strukturen mit ansonsten gleicher chemischer Zusammensetzung und Schichtdicke unterscheiden lassen, zeigen also eine deutliche Härtesteigerung gegenüber den entsprechenden kristallinen oder grob kristallinen Strukturen.

Ohne sich an eine Theorie binden zu wollen, erklären sich die Erfinder die außerordentliche Härtesteigerung der erfindungsgemäßen Schichten gegenüber kristallinen Schichten oder Schichten mit kristallen in amorpher Matrix nach dem Stand der Technik mit einer Veränderung der relativen Gleitfähigkeit der Netzebenen gegeneinander. Plastische Deformation geschieht in kristallinen Systemen der anmeldungsgemäßen Art durch ein Abgleiten der kristallinen Netzebenen gegeneinander, wobei die Netzebenen in dichtest gepackten Strukturen besonders bevorzugte Gleitebenen sind. Störungen der Gitterstrukturen durch starke Unordnung erschweren das Abgleiten der Netzebenen, vermindern so die Deformationsfähigkeit und erhöhen damit die Härte.

Des weiteren zeigen die erfindungsgemäßen Lagen gegenüber rein kristallinen Systemen eine geringere Wärmeleitfähigkeit, was erhebliche Vorteile für die Standzeiten der Werkzeuge mit sich bringen kann. Mit Blick auf die Ergebnisse der Elektronenbeugung und der XRD-Messungen erklären sich die Erfinder die Reduktion der Wärmeleitfähigkeit gegenüber entsprechenden rein kristallinen Systemen damit, dass die strukturelle Unordnung in den Körnern zu einer erhöhten Phononenstreuung aufgrund reduzierter freier Weglängen in den gestörten Strukturen führt. Messungen zeigten, dass eine erfindungsgemäße Al₂O₃-Schicht eine um etwa 10% geringere spezifische Wärmeleitfähigkeit aufwies als eine grobkristalline Al₂O₃-Schicht, die im CVD-Verfahren abgeschieden wurde. In einer bevorzugten Ausführungsform der Erfindung weist die wenigstens eine Metalloxidlage daher gegenüber einer rein kristallinen Metalloxidlage gleicher Zusammensetzung und Dicke eine um wenigstens 5 %, vorzugsweise um wenigstens 10 %, besonders bevorzugt um wenigstens 15 % geringere Wärmeleitfähigkeit auf.

Es folgen weitere vorteilhafte Ausführungsformen der vorliegenden Erfindung.

In einer Ausführungsform der Erfindung enthält die Metalloxidlage weiterhin unvermeidliche Verunreinigungen und/oder herstellungsbedingte Rückstände, vorzugsweise Argon (Ar), Stickstoff (N₂) und/oder Helium (He).

Die Körner in der erfindungsgemäßen Metalloxidlage besitzen zweckmäßigerweise mittlere Korngrößen im Bereich von 2 nm bis 5000 nm, bevorzugt 5 nm bis 2000 nm, weiter bevorzugt 10 nm bis 1000 nm, besonders bevorzugt 20 nm bis 100 nm.

Die wenigstens eine erfindungsgemäße Metalloxidlage kann mit Vorteil mittels dualem Magnetron-PVD-Verfahren mit folgenden Abscheidungsparametern abgeschieden werden:
Substrattemperatur von 300 bis 800 °C, vorzugsweise von 450 bis 650 °C, besonders bevorzugt etwa 550 °C,
Substratvorspannung von -300 bis 0 V, vorzugsweise etwa -150 V,
Leistung von 5 bis 50 kW, vorzugsweise etwa 20 kW,

Sauerstofffluss von 50 bis 300 sccm, vorzugsweise 150 sccm, mit 0,2 bis 0,6 Pa Ar-Gas. In einer weiteren Ausführungsform der Erfindung liegt die Dicke der wenigstens einen Metalloxidlage im Bereich von 0,2 bis 20 µm, vorzugsweise im Bereich von 0,5 bis 10 µm, besonders bevorzugt im Bereich von 1 bis 5 µm.

Die wenigstens eine erfindungsgemäße Metalloxidlage wird bevorzugt mittels PVD-Verfahren hergestellt, die besonders bevorzugt unter High Power-Impuls-Magnetron-Sputtern (HIPIMS), reaktivem Magnetron-Sputtern (rMS), Lichtbogenverdampfen (Arc-PVD), Ionenplattierung, E-lektronenstrahlverdampfung und Laserablation ausgewählt sind. Bei einer erfindungsgermäß mehrlagigen Beschichtung umfaßt die Beschichtung neben der wenigstens einen Metalloxidlage weitere Lagen, ausgewählt unter Carbiden, Nitriden, Oxiden, Carbonitriden, Oxinitriden, Oxicarbiden, Oxicarbonitriden, Boriden, Boronitriden, Borocarbide, Borocarbonitride, Borooxinitride, Borooxocarbide, Borooxocarbonitride, Oxoboronitriden der Elemente der Gruppen IVa bis VIIa des Periodensystems und/oder des Aluminiums und/oder des Siliziums, einschließlich gemischtmetallischen Phasen sowie Phasengemischen der vorgenannten Verbindungen.

In einer weiteren Ausführungsform der Erfindung ist der Substragrundkörper aus Hartmetall, Cermet, Stahl oder Schnellarbeitsstahl (HSS) hergestellt.

### Messmethoden

### 1. Elektronenbeugung (TEM)

Wenn hierin auf Elektronenbeugungsversuche Bezug genommen wird, so sind dies TEM-Messungen, die mit folgenden Bedingungen, Meßparametern, Geräten etc. durchgeführt worden.

### Transmissionselektronen-Mikroskop:

a) Zeiss 912 Omega
   Quelle LaB6
   Feinbereichsblende für Elektronenbeugung: 750 nm
   oder
b) Jeol 2000FXII
   Quelle LaB6
   Feinbereichsblende für Elektronenbeugung: 200 nm

### Probenpräpäration: oberflächenparallel

Von einem beschichteten Substratkörper wird eine 300 µm dicke Probe mit der abgeschiedenen Beschichtung parallel zur Substratoberfläche hergestellt, auf 100 µm gedünnt, mit einem Ultraschallkernlochbohrer zurecht geschnitten und mit der Beschichtungsseite auf einen Schleifhalter geklebt. Anschließend wird die Probe durch Schleifen auf Diamantfolie mit verschiedenen Körnungen (50 µm, 25 µm, 9 µm und 3 µm) von der Substratseite her manuell auf 20 µm gedünnt. Anschließend wird ein Al-Ring aufgeklebt und die Probe in der Ionenätzanlage (Baltec RES 100) mit 4kV bei 25mA von der Substratseite mit Argonionen geätzt und gedünnt, bis sie elektronentransparent ist.

### Probenpräparation: Querschnitt

Von einem beschichteten Substratkörper wird durch Abtrennen des Substratmaterials parallel zur Substratoberfläche eine Probe mit einer Restdicke von 1mm mit der abgeschiedenen Beschichtung hergestellt. Zwei der 1 mm dicken Reststücke werden an den Oberflächen (Beschichtungsaußenseiten; face to face) zusammengeklebt, ein Streifchen von dem Sandwich heruntergesägt und das Streifchen in ein Röhrchen eingebettet. Das Röhrchen wird in Scheibchen zersägt, die Scheibchen werden von beiden Seiten mit Diamantfolie poliert, und beide Seiten werden gedimpelt. Von beiden Seiten wird mit der Ionenätzanlage PIPS mit 4kV bei 25 mA geätzt.

### 2. XRD

Wenn hierin auf XRD-Messungen Bezug genommen wird, so sind diese mit folgenden Bedingungen, Meßparametern, Geräten etc. durchgeführt worden.

Die XRD-Messungen wurden in einem Mikrodiffraktometer der Firma Bruker unter Verwendung einer Strahlungsquelle mit einer Kobalt-Kathode, einer Anodenspannung von 30kV; einem Anodenstrom von 30mA, einem Graphit-Primärmonochromator (damit von der Quelle nur die Co-Kα-Strahlung verwendet wird) durchgeführt. Der Detektor war ein Bruker XAS D8-GADDS Discovery Detector. Der Röntgenstrahl wurde mit einer Monokapillare auf einen Durchmesser von 300µm fokussiert.
Messgeometrie: Streifender Einfall (Einfallswinkel konstant, Bragg-Winkel wurde variiert)

### 3. Bestimmung der Vickers-Härte

Wenn hierin auf Vickers-Härte-Messungen Bezug genommen wird, so sind diese mit folgenden Bedingungen, Meßparametern, Geräten etc. durchgeführt worden.

Härtemessungen wurde auf einem Fischerscope@H100 (Helmut Fischer GmbH, Sindelfingen, Deutschland) mit einer Prüflast von 15 mN bei einer Belastungsdauer von 1 min (Belastungsrate = 15 mN/min) durchgeführt. Als Prüfspitze wurde eine Vickers Pyramide verwendet. Die Auflösung der Eindringtiefe war ±2nm, und die Auflösung der Last war ±0.04mN. Vor der Messung wurde die Probe wegen der Oberflächenrauheit poliert und entmagnetisiert.

### 4. Bestimmung der Wärmeleitfähigkeit

Wenn hierin auf Wärmeleitfähigkeits-Messungen Bezug genommen wird, so sind diese mit folgenden Bedingungen, Meßparametern, Geräten etc. durchgeführt worden.

Für die Messung der Wärmeleitfähigkeit wird ein Substrat mit einer Beschichtung auf genau einer der Oberflächen homogen auf eine Temperatur von 81 °C aufgeheizt. Anschließend wird die Beheizung abgebrochen und das Substrat mit der beschichteten Seite auf ein großes, gut wärmeleitendes Metallstück aufgelegt. Das Substrat dient bei dieser Messung als Wärmereservoir. Das große, gut wärmeleitende Metallstück dient als Wärmebad mit näherungsweise konstanter Temperatur, die unterhalb der Aufheiztemperatur des Substrates liegt, vorzugsweise bei Raumtemperatur. Durch die Beschichtung fließt ein Wärmestrom vom Wärmereservoir zum Wärmebad, wodurch sich das Substrat abkühlt. Die Messgröße ist die Substrattemperatur auf der der Beschichtung abgewandten Seite des Substrates als Funktion der Zeit. Aus der Abkühlkurve wird die spezifische Wärmeleitungskonstante bestimmt. Das Experiment wird unter gleichen Bedingungen für die verschiedenen zu vergleichenden Schichten durchgeführt.

Die neuartige Beschichtung der vorliegenden Erfindung eröffnet ein breites Spektrum an Möglichkeiten zur Verbesserung und/oder Anpassung der Verschleißfestigkeit, der Standzeiten und/oder der Schneideigenschaften von Schneidwerkzeugen.

Die Verschleißbeständigkeit, Standfestigkeit und Schneideigenschaften einer Beschichtung auf einem Schneidwerkzeug hängt von verschiedenen Faktoren ab, wie beispielsweise dem Material des Grundkörpers des Schneidwerkzeugs, der Abfolge, Art und Zusammensetzung der in der Beschichtung vorhandenen Lagen, der Dicke der verschiedenen Lagen und nicht zuletzt der Art der mit dem Schneidwerkzeug durchgeführten Schneidoperation. Für ein und dasselbe Schneidwerkzeug können sich unterschiedliche Verschleißfestigkeiten in Abhängigkeit von der Art des zu bearbeitenden Werkstücks, dem jeweiligen Bearbeitungsverfahren und den weiteren Bedingungen während der Bearbeitung, wie beispielweise Entwicklung hoher Temperaturen oder Verwendung korrosiver Kühlflüssigkeiten, ergeben. Darüber hinaus unterscheidet man zwischen verschiedenen Verschleißarten, die je nach Bearbeitungsvorgang die Nutzungsdauer eines Werkzeugs, d. h. seine Standzeit, stärker oder geringer beeinflussen können. Die Weiterentwicklung und Verbesserung von Schneidwerkzeugen ist daher stets im Hinblick darauf zu betrachten, welche Werkzeugeigenschaften verbessert werden sollen, und unter vergleichbaren Bedingungen gegenüber dem Stand der Technik zu beurteilen.

Eine wesentliche Eigenschaft von Schneidwerkzeugen, die durch die erfindungsgemäße Beschichtung gegenüber dem Stand der Technik mit Beschichtungen aus den gleichen Materialien verbessert wird, ist die Härte einer solchen Beschichtung. Die deutlich höhere Härte der erfindungsgemäßen Beschichtung wird auf die einzigartigen strukturellen Eigenschaften zurückgeführt, die bei der erfindungsgemäßen Beschichtung gemäß TEM-Messungen vorliegen.

Die bei erfindungsgemäßen Beschichtungen überraschend erreichte Reduzierung der Wärmeleitfähigkeit der Metalloxidlage und damit üblicherweise auch der Gesamtbeschichtung wirkt sich sehr positiv im Einsatz solcher Schneidwerkzeuge bei der Zerspanung von Metallen und Verbundmaterialien aus. Die reduzierte Wärmeleitfähigkeit führt zu einer verbesserten Thermoschockbeständigkeit und damit zu erhöhter Kammrissfestigkeit.

Es versteht sich von selbst, dass sämtliche Einzelmerkmale, wie sie für bestimmte erfindungsgemäße Ausführungsformen hierin beschrieben sind, soweit dies technisch sinnvoll und möglich ist, mit allen übrigen beschriebenen Merkmalen erfindungsgemäßer Ausführungsformen kombinierbar sind und solche Kombinationen als im Rahmen dieser Beschreibung offenbart angesehen werden. Auf die einzelne Benennung sämtlicher möglicher Kombinationen wird hierin lediglich aus Gründen der besseren Lesbarkeit verzichtet.

Weitere Vorteile, Merkmale und Ausführungsformen der vorliegenden Erfindung werden anhand der nachfolgenden Beispiele erläutert.

### Beispiele

In einer PVD-Beschichtungsanlage (Flexicoat; Hauzer Techno Coating BV, Venlo, Niederlande) wurden Hartmetallsubstrate im dualen Magnetron-Verfahren mit einer einlagigen Beschichtung versehen. Die Substratgeometrie war SEHW120408 bzw. ADMT160608-F56 (nach DIN-ISO 1832). Vor der Abscheidung der Lagen wurde die Anlage auf 1x10⁻⁵ mbar evakuiert und die Hartmetalloberfläche durch Argon-Ionenätzen mit 170 V Vorspannung gereinigt.

### Beispiel 1

### Metalloxid: Al₂O₃

▪ PVD-Verfahren: duales Magnetron
▪ Target: Al-Rechtecktarget (81 cm x 16 cm)
▪ Abscheidung: Substrattemperatur: 550°C
   Substratvorspannung: -150 Volt (DC gepulst 100 kHz, 2 µs Off-Time)
   Leistung: 20 kW
   Sauerstofffluss: 150 sccm mit 0,6 Pa Ar-Gas
   Schichtdicke: 2,1 µm

### Vergleichsbeispiel 1

### Metalloxid: Al₂O₃

▪ PVD-Verfahren: Single-Magnetron
▪ Target: Al-Rechtecktarget (81 cm x 16 cm)
▪ Abscheidung: Substrattemperatur: 550°C
   Substratvorspannung: -120 Volt
   Leistung: 10 kW
   Sauerstofffluss: 150 sccm mit 0,6 Pa Ar-Gas
   Schichtdicke: 1,9 µm

### Beispiel 2

### Metalloxid: (Al, Cr)₂O₃

▪ PVD-Verfahren: duales Magnetron
▪ Target: AI/Cr-(70/30 At.-%)-Rechtecktarget (81 cm x 16 cm)
▪ Abscheidung: Substrattemperatur: 550°C
   Substratvorspannung: -100 Volt (DC gepulst 70 kHz, 4 µs Off-Time)
   Leistung: 20 kW
   Sauerstofffluss: 150 sccm mit 0,2 Pa Ar-Gas
   Schichtdicke: 3,3 µm

### Vergleichsbeispiel 2

### Metalloxid: (Al, Cr)₂O₃

▪ PVD-Verfahren: Lichtbogenverdampfen
▪ Target: AI/Cr-(70/30 At.-%)-Rundquelle (16 cm Durchmesser)
▪ Abscheidung: Substrattemperatur: 550°C
   Verdampferstrom: 2 x 160 A
   Biasvorspannung: -60 V (bipolar)
   Sauerstofffluss: 500 sccm (kein Ar-Gas)
   Schichtdicke: 2,5 µm

Die Ergebnisse der TEM-Messungen zeigten, dass die Al₂O₃- und (Al, Cr)₂O₃-Schichten gemäß den Beispielen 1 und 2 die erfindungsgemäße Struktur aufwiesen, bei der innerhalb einer Mehrzahl der vorhandenen Körner eine strukturelle Unordnungen vorhanden ist, aber dennoch eine Art der Fernordnung bzw. Kristallinität vorliegt. Die Beschichtungen zeigen zudem im XRD wenige aber breite Reflexe und eine sehr hohe Intensität des Untergrunds.

Im Gegensatz dazu zeigten die Ergebnisse der TEM- und XRD-Messungen weiterhin, dass die Al₂O₃-Schicht gemäß Vergleichsbeispiel 1 vollständig amorph war und die (Al, Cr)₂O₃-Schicht gemäß Vergleichsbeispiel 2 kristallin war.

Bestimmungen der Vickers-Härten der Schichten gemäß den Beispielen und Vergleichsbeispielen zeigten, dass die erfindungsgemäßen Strukturen gegenüber amorphen Strukturen gleicher Zusammensetzung eine deutlich höhere Härte besitzen (siehe Tabelle 2).

**Tabelle 2: Bestimmung der Vickers-Härten**

| | Vickers-Härte [HV] |
|---|---|
| **Beispiel 1:** | 2720 HV |
| **Vergleichsbeispiel 1:** | 1064 HV |
| | |
| **Beispiel 2:** | 3800 HV |
| **Vergleichsbeispiel 2:** | 2500 HV |

### Wärmeleitfähigkeit

Nach der oben beschriebenen Methode wurde unter Berücksichtigung der Schichtdicke die Wärmeleitfähigkeit der Al₂O₃-Beschichtung gemäß Beispiel 1 verglichen mit einer im CVD-Verfahren abgeschiedenen grobkristallinen α-Al₂O₃-Beschichtung (Schichtdicke: 5 µm). Die Wärmeleitfähigkeit der erfindungsgemäßen Al₂O₃-Beschichtung gemäß Beispiel 1 war um ca. 10 % geringer als diejenige der im CVD-Verfahren aufgebrachten Beschichtung.

### Fräsversuche

In Fräsversuchen an einem Werkstück aus 42CrMoV4-Stahl (1.7226; Festigkeit: 850 MPa) wurden die Schneidwerkzeuge aus den Beispielen und Vergleichsbeispielen untersucht. In diesen Versuchen wurde im Gleichlauf ohne Kühlschmierstoff mit einer Schnittgeschwindigkeit v_{c} = 235 m/min, einem Zahnvorschub f_{z} = 0,2 mm/Zahn und einer Schnitttiefe von 3 mm gefräst. Der Werkzeugdurchmesser betrug 125mm, die Schnittbreite war 98mm, der Überstand betrug 5mm, der Einstellwinkel kappa betrug 45° und der Spanwinkel 0°. Der Verschleiß wurde auf der Freifläche als mittlere Verschleißmarkenbreite VB in mm (an der Hauptschneide) nach Fräswegen von 800 mm, 1600 mm, 2400 mm, 3200 mm, 4000 mm und 4800 mm gemessen. Es wurden folgende Verschleißmarkenbreiten V_{Bmax} festgestellt (Tabelle 3):

**Tabelle 3: Fräsversuche**

| **Fräsweg [mm]** | **Verschleißmarkenbreiten** | **V_{Bmax}[mm]** |
|---|---|---|
| | **Beispiel 1** | **Vergleichsbeispiel 1** |
| **800** | 0,02 | 0,03 |
| **1600** | 0,03 | 0,05 |
| **2400** | 0,03 | 0,06 |
| **3200** | 0,04 | 0,09 |
| **4000** | 0,06 | 0,12 |
| **4800** | 0,08 | 0,13 |

## Patentansprüche

1. Schneidwerkzeug mit einem Substratgrundkörper aus Hartmetall, Cermet, Stahl oder Schnellarbeitsstahl (HSS) und einer darauf aufgebrachten ein- oder mehrlagigen Beschichtung,
wobei wenigstens eine Lage der Beschichtung eine im PVD-Verfahren hergestellte Metalloxidlage ist, welche Körner aus Aluminiumoxid oder Aluminium-Chrom-Oxid enthält oder daraus besteht, und
die Metalloxidlage eine Kornstruktur aufweist, bei der innerhalb einer Mehrzahl der vorhandenen Körner strukturelle Unordnungen vorhanden sind, die dadurch charakterisiert sind, dass
in den Elektronenbeugungsbildern der Körner bis zu einem maximalen Netzebenenabstand d_{GRENZ} von 0,2 nm punktförmige Reflexe auftreten und für Netzebenenabstände größer d_{GRENZ} keine punktförmigen Reflexe auftreten, sondern eine für amorphe Strukturen typische Intensitätsverteilung,
wobei in einer mehrlagigen Beschichtung weitere Lagen neben der wenigstens einen Metalloxidlage unter Carbiden, Nitriden, Oxiden, Carbonitriden, Oxinitriden, Oxicarbiden, Oxicarbonitriden, Boriden, Boronitriden, Borocarbide, Borocarbonitride, Borooxinitride, Borooxocarbide, Borooxocarbonitride, Oxoboronitriden der Elemente der Gruppen IVa bis Vlla des Periodensystems und/oder des Aluminiums und/oder des Siliziums, einschließlich gemischtmetallischen Phasen sowie Phasengemischen der vorgenannten Verbindungen, ausgewählt sind.

2. Schneidwerkzeug nach einem der vorangegangenen Ansprüche, **dadurch gekennzeichnet, dass** die wenigstens eine Metalloxidlage gegenüber einer rein kristallinen Metalloxidlage gleicher Zusammensetzung und Dicke eine um wenigstens 5 %, vorzugsweise um wenigstens 10 %, besonders bevorzugt um wenigstens 15 % geringere Wärmeleitfähigkeit aufweist.

3. Schneidwerkzeug nach einem der vorangegangenen Ansprüche, **dadurch gekennzeichnet, dass** die wenigstens eine Metalloxidlage gegenüber einer rein kristallinen Metalloxidlage gleicher Zusammensetzung und Dicke eine um 10%, bevorzugt um 20%, weiter bevorzugt um 40%, besonders bevorzugt um 70% höhere Vickers-Härte aufweist.

4. Schneidwerkzeug nach einem der vorangegangenen Ansprüche, **dadurch gekennzeichnet, dass** die Metalloxidlage weiterhin unvermeidliche Verunreinigungen und/oder herstellungsbedingte Rückstände, vorzugsweise Argon (Ar), Stickstoff (N₂) und/oder Helium (He), enthält.

5. Schneidwerkzeug nach einem der vorangegangenen Ansprüche, **dadurch gekennzeichnet, dass** die Körner in der Metalloxidlage mittlere Korngrößen im Bereich von 2 nm bis 5000 nm, bevorzugt 5 nm bis 2000 nm, weiter bevorzugt 10 nm bis 1000 nm, besonders bevorzugt 20 nm bis 100 nm aufweisen.

6. Schneidwerkzeug nach einem der vorangegangenen Ansprüche, **dadurch gekennzeichnet, dass** die Dicke der wenigstens einen Metalloxidlage im Bereich von 0,2 bis 20 µm liegt, vorzugsweise im Bereich von 0,5 bis 10 µm, besonders bevorzugt im Bereich von 1 bis 5 µm.

## Claims

1. A cutting tool having a substrate main body made of hard metal, cermet, steel or highspeed steel (HSS) and a single-layer or multi-layer coating applied thereto,
wherein at least one layer of the coating is a metal oxide layer produced in the PVD process which comprises or is made of grains of aluminium oxide or aluminium-chromium oxide, and
the metal oxide layer has a grain structure in which there are present within a plurality of the existing grains structural disorders which are **characterised in that** point-shaped reflections occur in the electron diffraction images of the grains up to a maximum lattice plane spacing D_{LIMIT} of 0.2 nm and for lattice plane spacings of greater than d_{LIMIT} no point-shaped reflections occur, but an intensity distribution that is typical for amorphous structures,
wherein in a multi-layer coating further layers, in addition to the at least one metal oxide layer, are selected from carbides, nitrides, oxides, carbonitrides, oxynitrides, oxycarbides, oxycarbonitrides, borides, boron nitrides, borocarbides, borocarbonitrides, borooxynitrides, borooxocarbides, borooxocarbonitrides and oxoboronitrides of the elements of groups IVa to VIIa of the periodic system and/or aluminium and/or silicon, including mixed-metallic phases and phase mixtures of the aforementioned compounds.

2. A cutting tool according to one of the preceding claims **characterised in that** the at least one metal oxide layer has a thermal conductivity which is lower by at least 5%, preferably by at least 10%, particularly preferably by at least 15%, in comparison with a purely crystalline metal oxide layer of the same composition and thickness.

3. A cutting tool according to one of the preceding claims **characterised in that** the at least one metal oxide layer has a Vickers hardness which is higher by 10%, preferably by 20%, further preferably by 40%, particularly preferably by 70%, in comparison with a purely crystalline metal oxide layer of the same composition and thickness.

4. A cutting tool according to one of the preceding claims **characterised in that** the metal oxide layer further includes inevitable impurities and/or manufacture-induced residues, preferably argon (Ar), nitrogen (N₂) and/or helium (He).

5. A cutting tool according to one of the preceding claims **characterised in that** the grains in the metal oxide layer have mean grain sizes in the range of 2 nm to 5000 nm, preferably 5 nm to 2000 nm, further preferably 10 nm to 1000 nm, particularly preferably 20 nm to 100 nm.

6. A cutting tool according to one of the preceding claims **characterised in that** the thickness of the at least one metal oxide layer is in the range of 0.2 to 20 µm, preferably in the range of 0.5 to 10 µm, particularly preferably in the range of 1 to 5 µm.

## Revendications

1. Outil de coupe ayant un corps de base formant un substrat en métal dur, cermet, acier ou acier à coupe rapide (HSS) et déposé dessus un revêtement d'une ou de plusieurs couches,
au moins une couche du revêtement étant une couche d'un oxyde de métal réalisée au moyen d'un procédé de dépôt en phase vapeur, et comprenant ou étant constituée de grains d'oxyde d'aluminium ou d'oxyde d'aluminium-chrome ou en est constituée, et
la couche d'oxyde de métal présentant une structure granulaire dans laquelle, à l'intérieur d'une pluralité des grains présents, des désordres structurels sont présents qui sont **caractérisés en ce que** sur les images de diffraction électronique des grains, des points de réflexion apparaissent jusqu'à une distance de plans de réseau maximale d_{GRENZ} de 0,2 nm et qu'il n'apparaît pas de points de réflexion à des distances de plan de réseau supérieures à d_{GRENZ} mais qu'il y a une répartition d'intensité typique des structures amorphes, dans des revêtements à plusieurs couches, d'autres couches, outre ladite au moins une couche en oxyde de métal, sont sélectionnées parmi les carbures, les nitrures, les oxydes, les carbonitrures, les oxynitrures, les oxycarbures, les oxycarbonitrures, les borures, les nitrures de bore, les carbures de bore, les carbonitrures de bore, les oxynitrures de bore, les oxycarbures de bore, les oxycarbonitrures de bore, les oxonitrures de bore des éléments des groupes IVa à VIIa du système périodique et/ou de l'aluminium et/ou du silicium, y compris des phases de métaux mélangés ainsi que des mélanges de phases des composés précités.

2. Outil de coupe selon la revendication 1, **caractérisé en ce que** ladite au moins une couche d'oxyde de métal présente, par rapport à une couche d'oxyde de métal cristalline pure de même composition et épaisseur, une conductivité thermique inférieure d'au moins 5 %, de préférence d'au moins 10 % et particulièrement préférée d'au moins 15 %.

3. Outil de coupe selon l'une des revendications précédentes, **caractérisé en ce que** ladite au moins une couche d'oxyde de métal présente, par rapport à une couche d'oxyde de métal cristalline pure de même composition et épaisseur, une dureté Vickers plus grande de 10 %, de préférence de 20 %, de manière davantage préférée de 40 %, de manière particulièrement préférée de 70 %.

4. Outil de coupe selon l'une des revendications précédentes, **caractérisé en ce que** la couche d'oxyde de métal comprend en outre des impuretés inévitables et/ou des résidus liés à la fabrication, de préférence de l'argon (Ar), de l'azote (N₂) et/ou de l'hélium (He).

5. Outil de coupe selon l'une des revendications précédentes, **caractérisé en ce que** les grains dans la couche d'oxyde de métal présentent une grosseur moyenne de grains dans la plage de 2 nm à 5000 nm, de préférence de 5 nm à 2000 nm, de manière davantage préférée de 10 nm à 1000 nm, de manière particulièrement préférée de 20 nm à 100 nm.

6. Outil de coupe selon l'une des revendications précédentes, **caractérisé en ce que** l'épaisseur de ladite au moins une couche d'oxyde de métal est dans la plage de 0,2 à 20 µm, de préférence dans la plage de 0,5 à 10 µm, de manière particulièrement préférée dans la plage de 1 à 5 µm.
